# EUROPEAN PATENT APPLICATION

(11) **EP 4 848 527 A1**
(43) Date of publication of application: **02.12.2026**
(21) Application number: 25840818.6
(22) Date of filing: 17.09.2025
(51) Int. Cl.: H02J 7/00, G01R 31/3835, G01R 31/396, G01R 19/165, H01M 10/42, H01M 10/44

(54) **BATTERY PACK FOR CONTROLLING CHARGING OR DISCHARGING, AND CONTROLLING METHOD THEREOF**

(30) Priority: 17.07.2024 KR 20240094134
(71) Applicant: LG Energy Solution, Ltd., Seoul 07335 (KR)
(72) Inventor: KIM, Hak In, Daejeon 34122 (KR)
(74) Representative: Plasseraud IP
(86) International application number: PCT/IB2025/059293
(87) International publication number: WO 2026/018231

(57) **Abstract**

The present invention relates to a battery pack and a control method thereof for charge and discharge control, which eliminates an impedance difference between battery packs generated upon parallel connection in a low-temperature or high-temperature environment by consuming a charging current between the battery packs to protect the battery packs.

## Description

### [TECHNICAL FIELD]

The present invention relates to a battery pack, and more particularly, to a battery pack and a control method thereof that minimize energy consumption by effectively resolving an imbalance between battery packs that occurs during parallel connection in low or high-temperature environments outside a normal operating temperature range of the battery.

### [BACKGROUND ART]

Recently, there has been a growing interest in electrical products that can be driven using electrical energy. Accordingly, technological development and demand for mobile devices, electric vehicles, hybrid vehicles, power storage devices, uninterruptible power supplies, etc., are increasing, and the demand for secondary batteries as an energy source is rapidly increasing.

To provide high-power or large-capacity electricity, such secondary batteries are configured as battery packs by connecting multiple cell assemblies, which are composed of unit cell aggregates, in series or parallel, thereby supplying a desired output or power. High-performance electric vehicles requiring large capacity use multiple such battery packs connected in parallel.

When battery packs are used in a parallel connection, even after the charging of the battery packs is completed, a voltage difference occurs between the battery packs due to differences in their impedance. This voltage difference causes a charging current to flow from the battery pack with a higher voltage to the battery pack with a lower voltage. For example, if a first battery pack with a charging voltage of 57.08V and a resistance of 0.024Ω is connected in parallel with a second battery pack with a charging voltage of 57.05V and a resistance of 0.026Ω, a charging current of 600mA is generated from the second battery pack to the first battery pack.

However, particularly in abnormal temperature environments where charging is difficult, such as low temperatures below 0°C or high temperatures above 55°C, the charging voltage of the battery packs changes significantly, which can lead to a much larger difference in charging voltage between the battery packs. That is, in abnormal temperature environments, the charging current applied between parallel-connected battery packs can be even larger.

The charging current from another battery pack applied during the connection of battery packs can cause damage to the battery cells constituting the battery pack. That is, battery cells have a predetermined Power Specification (PS). Accordingly, if a charging current exceeding the PS is applied to a battery cell with a lower voltage, the battery cell may be damaged. In particular, even if battery cells have the same PS, their charge/discharge temperature ranges differ, so charging at low or high temperatures outside the normal charging range can cause even greater damage to the battery cells.

Below are the related prior arts.
(Patent Document 1) Korean Laid-open Patent Publication No. 10-2010-0005104 (Published on Jan. 13, 2010)
(Patent Document 2) Korean Laid-open Patent Publication No. 10-2020-0041706 (Published on Apr. 22, 2020)

### [SUMMARY OF THE INVENTION]

### [TECHNICAL PROBLEM]

The present invention aims to provide a battery pack for charge/discharge control and a control method thereof that resolves the impedance difference between battery packs, which occurs during parallel connection in low or high-temperature environments, by consuming the charging current between the battery packs for their protection.

The present invention aims to provide a battery pack for charge/discharge control and a control method thereof that prevents damage to battery cells by configuring a charging/discharging device that consumes the charging current generated during parallel connection of battery packs at low or high temperatures. Furthermore, the present invention aims to provide a battery pack for charge/discharge control and a control method thereof that stores the charging current consumed by the charging/discharging device and then charges the battery pack when conditions (normal temperature) become suitable for charging.

### [SOLUTION TO PROBLEM]

A battery pack for controlling charging/discharging according to an embodiment of the present invention includes: a cell assembly comprising a plurality of battery cells and electrically connected to pack input/output terminals (a+, a-) through a first charging/discharging path (c); a first charging/discharging switch configured between the cell assembly and the pack input/output terminal (a+), for connecting or disconnecting the first charging/discharging path (c) according to a turn-on or turn-off operating state; a second charging/discharging switch configured on a path that branches off between the first charging/discharging switch and the pack input/output terminal (a+) and connects to the pack input/output terminal (a-), for connecting or disconnecting a second charging/discharging path (d) according to a turn-on or turn-off operating state; a charging/discharging unit configured between the second charging/discharging switch and the pack input/output terminal (a-), for consuming the charging current applied between parallel-connected battery packs; and a control unit for controlling the operating state of the first and second charging/discharging switches to a turn-on or turn-off state.

The first charging/discharging switch is turned off in an abnormal temperature environment in which a charging problem occurs, thereby disconnecting the first charging/discharging path (c), and is turned on in a normal temperature environment other than the abnormal temperature environment, thereby connecting the first charging/discharging path (c).

The second charging/discharging switch is turned on in an abnormal temperature environment in which a charging problem occurs, thereby connecting the second charging/discharging path (d), and is turned off in a normal temperature environment other than the abnormal temperature, thereby disconnecting the second charging/discharging path (d).

The charging/discharging unit stores charge from current supplied from the first charging/discharging path (c) under an abnormal temperature environment in which a charging problem occurs, and discharges the charge stored therein in a normal temperature environment other than the abnormal temperature environment, thereby allowing a current from the charging/discharging unit to flow through the first charging/discharging path (c).

The control unit controls the first charging/discharging switch to turn off and the second charging/discharging switch to turn on in an abnormal temperature environment where a temperature of the battery pack causes a problem with charging, and controls the first charging/discharging switch to turn on and the second charging/discharging switch to turn on in a normal temperature environment other than the abnormal temperature for the temperature of the battery pack.

The control unit, upon connection of battery packs, checks the connection status with the battery pack and the voltage of the battery pack via CAN communication to compare the voltages between the connected battery packs.

The control unit measures the voltage of the charging/discharging unit to check the charge and discharge state of the charging/discharging unit.

The control unit controls the second charging/discharging switch to remain turned on while the charge stored in the charging/discharging unit is being discharged, and controls the second charging/discharging switch to turn off once all the charge in the charging/discharging unit has been discharged.

The pack input/output terminals (a+, a-) are electrically connected to the pack input/output terminals (b+, b-) of another battery pack mounted in the battery system (S) and to the system input/output terminals (P+, P-) of the battery system (S), respectively.

The abnormal temperature is a low temperature of 0°C or below, or a high temperature of 45°C or 55°C or above, and the normal temperature range may be between 0°C and 55°C, or between 0°C and 45°C.

A method for controlling charging/discharging of a battery pack according to an embodiment of the present invention includes the steps of: (A) detecting, by a control unit, whether a first battery pack is electrically connected in parallel with a second battery pack via CAN communication, and checking a voltage of the first battery pack that is connected in parallel; (B) connecting a first charging/discharging path (c) for charging/discharging the battery cells if the voltage of the first battery pack is lower than the voltage of the second battery pack and the temperature of the first battery pack is within a normal temperature range where there are no charging issues; (C) disconnecting the first charging/discharging path (c) if the voltage of the first battery pack is lower than the voltage of the second battery pack and the temperature of the first battery pack is within an abnormal temperature range where charging problems occur; (D) connecting a second charging/discharging path (d) that consumes the charging current applied from the second battery pack (200); and (E) consuming, by a charging/discharging unit, the charging current applied to the second charging/discharging path (d).

The step (B) further includes the step of disconnecting the second charging/discharging path (d) that consumes the charging current applied from the second battery pack.

The step (B) includes the steps of: controlling, by the control unit, the operating state of a first charging/discharging switch configured in the first battery pack to be turned on to connect the first charging/discharging path (c); and controlling, by the control unit, the operating state of a second charging/discharging switch configured in the first battery pack to be turned off to disconnect the second charging/discharging path (d).

The step (C) includes the step of controlling, by the control unit, the operating state of the first charging/discharging switch configured in the first battery pack to be turned off to disconnect the first charging/discharging path (c).

The step (D) includes the step of controlling, by the control unit, the operating state of the second charging/discharging switch configured in the first battery pack to be turned on to connect the second charging/discharging path (d).

The step (E) includes the steps of: (E1) charging the charging/discharging unit with the electric charge from the charging current applied to the second charging/discharging path (d); and (E2) after the charging/discharging unit is charged, if the temperature of the first battery pack is within the normal temperature range, connecting the first charging/discharging path (c) and the second charging/discharging path (d), thereby allowing a current from the charging/discharging unit to flow through the first charging/discharging path (c).

The step (E2) includes the steps of: measuring, by the control unit, the voltage of the charging/discharging unit to determine that the charging/discharging unit has been charged; and if, as a result of the determination, the charging/discharging unit has been charged, controlling, by the control unit, the operating state of the first charging/discharging switch to be turned on to connect the first charging/discharging path (c).

The step (E2) further includes the steps of: measuring, by the control unit, the voltage of the charging/discharging unit to determine that the charge in the charging/discharging unit has been discharged; if, as a result of the determination, the charge stored in the charging/discharging unit has not been fully discharged, controlling, by the control unit, the operating state of the second charging/discharging switch to be turned on to connect the second charging/discharging path (d); and if, as a result of the determination, the charge stored in the charging/discharging unit has been fully discharged, controlling, by the control unit, the operating state of the second charging/discharging switch to be turned off to disconnect the second charging/discharging path (d).

### [ADVANTAGEOUS EFFECTS OF THE INVENTION]

According to an embodiment of the present invention, it is possible to resolve problems caused by charging between battery packs during parallel connection in low or high-temperature environments (environments where charging should not occur) by consuming the charging current between the battery packs for their protection. In particular, the safety of the battery pack can be enhanced by designing it to prevent damage to the battery cells even when connected in an abnormal temperature environment.

Furthermore, by configuring a charging/discharging device that consumes the charging current generated during parallel connection of battery packs, storing the consumed charging current, and then charging the battery pack when conditions are suitable for charging, energy consumption can be minimized.

### [BRIEF DESCRIPTION OF THE DRAWINGS]

FIG. 1 is a diagram showing the configuration of a battery pack for charge/discharge control according to an embodiment of the present invention.
FIG. 2 is a diagram showing the internal configuration of the battery pack of FIG. 1 in detail.
FIG. 3 is a flowchart for explaining a method for controlling the charging/discharging of a battery pack according to an embodiment of the present invention.
FIG. 4 is a flowchart for explaining the method of consuming charging current in FIG. 3.
FIG. 5 is a flowchart for explaining step S300 of FIG. 4 in detail.
FIG. 6 is a flowchart for explaining step S400 of FIG. 4 in detail.

### [DETAILED DESCRIPTION OF THE EMBODIMENTS]

Hereinafter, embodiments of the present invention will be described in detail with reference to the accompanying drawings. However, the present invention is not limited to the embodiments disclosed below but may be implemented in various different forms. The embodiments are provided merely to complete the disclosure of the present invention and to fully inform a person of ordinary skill in the art of the scope of the invention. To clearly describe the invention, the drawings may be exaggerated, and like reference numerals in the drawings denote like elements.

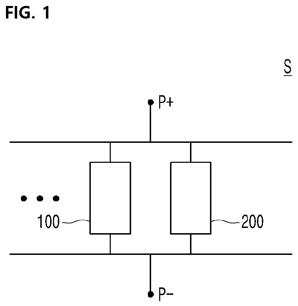

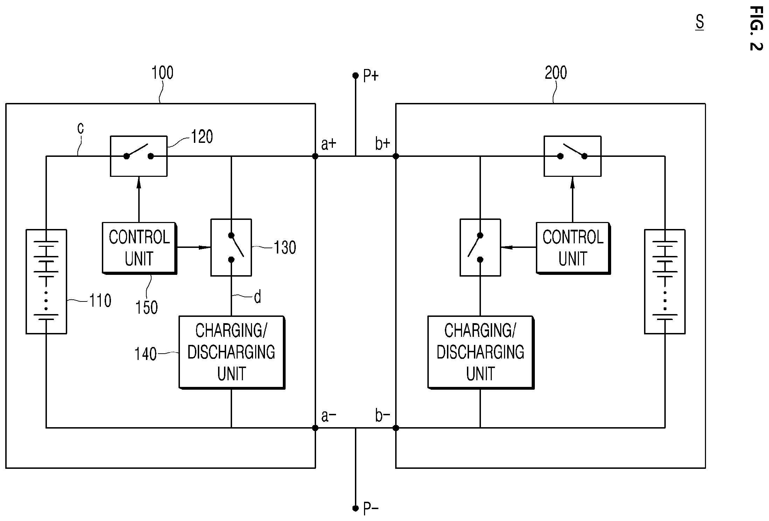

FIG. 1 is a diagram showing the configuration of parallel-connected battery packs according to an embodiment of the present invention, and FIG. 2 is a diagram showing the internal configuration of the battery pack of FIG. 1 in detail.

Referring to FIGS. 1 and 2, a battery system (S) may have a plurality of battery packs (100)(200) connected in parallel. That is, the battery system (S) of the present invention has a plurality of battery packs (100)(200) electrically connected in parallel and can output power to a load through the input/output terminals (P+, P-) of the battery system (S).

The plurality of battery packs (100)(200) may be detachable from the battery system (S). When one of the plurality of battery packs, battery pack (100), is mounted in the battery system (S), it can be electrically connected in parallel with another battery pack (200) already mounted in the battery system (S). In this specification, the battery system (S) is described as having two battery packs (100)(200) mounted, but three or more battery packs can be mounted and connected in parallel.

A battery pack (100) for controlling charging/discharging according to an embodiment of the present invention includes a cell assembly (110), a first charging/discharging switch (120), a second charging/discharging switch (130), a charging/discharging unit (140), and a control unit (150). The battery pack (100) for controlling charging/discharging further includes a first charging/discharging path (c), a second charging/discharging path (d), and pack input/output terminals (a+, a-).

The cell assembly (110) may include a plurality of battery cells. The cell assembly (110) can be electrically connected to the pack input/output terminals (a+, a-) through the first charging/discharging path (c). Through this, the cell assembly (110) can be charged or discharged by receiving or outputting current through the first charging/discharging path (c) while the first charging/discharging switch (120) located on the first charging/discharging path (c) is turned on. Conversely, the charging/discharging of the cell assembly (110) can be suspended while the first charging/discharging switch (120) is turned off.

The first charging/discharging switch (120) may be composed of at least one FET (Field Effect Transistor). The first charging/discharging switch (120) is configured between the cell assembly (110) and the pack input/output terminal (a+) and connects (on) or disconnects (off) the first charging/discharging path (c) according to its turn-on or turn-off operating state. As an embodiment, the first charging/discharging switch (120) is turned off in an abnormal temperature environment where the battery pack (100) should not be charged (e.g., low temperature below 0°C or high temperature above 55°C), thereby disconnecting the first charging/discharging path (c). Conversely, the first charging/discharging switch (120) is turned on in a normal temperature range other than the abnormal temperature (e.g., between 0°C and 55°C for charging, -20°C to 60°C for discharging), thereby connecting the first charging/discharging path (c). The normal charge/discharge temperature range of the battery pack can be set according to the characteristics of the battery pack or the system. The abnormal temperature is a low temperature of 0°C or below, or a high temperature of 45°C or 55°C or above, and the normal temperature range may be between 0°C and 55°C, or between 0°C and 45°C.

The second charging/discharging switch (130) may be composed of at least one FET and a resistor connected in series with the FET. The second charging/discharging switch (130) is configured on a path that branches off from the first charging/discharging path (c) between the first charging/discharging switch (120) and the pack input/output terminal (a+) and connects to the pack input/output terminal (a-), connecting or disconnecting the second charging/discharging path (d) according to its turn-on or turn-off operating state. As an embodiment, the second charging/discharging switch (130) is turned on in an abnormal temperature environment of the battery pack (100), thereby connecting the second charging/discharging path (d).

The charging/discharging unit (140) may be configured to include at least one capacitor. The charging/discharging unit (140) is configured between the second charging/discharging switch (130) and the pack input/output terminal (a-) on the second charging/discharging path (d) and stores the charging current applied between the parallel-connected battery packs (100)(200). The control unit (150), in an abnormal temperature environment of the battery pack (100), opens the first charging/discharging switch (120) and closes the second charging/discharging switch (130), thereby charging the charging/discharging unit (140) with the electric charge from the current applied from the other battery pack (200).

The control unit (150) can check the connection status with another battery pack (200) and the voltages of the battery packs (100, 200) via CAN communication upon connection, to compare the voltages between the parallel-connected battery packs. The control unit (150) measures the voltage of the charging/discharging unit (140), and if it confirms that the charging/discharging unit (140) is charged, or if no more charge is being stored in the charging/discharging unit (140), it can open the second charging/discharging switch (130) to stop charging the charging/discharging unit (140).

When the temperature of the battery pack (100) returns to a normal temperature environment, the control unit (150) reconnects the first charging/discharging switch (120) and the second charging/discharging switch (130) to discharge the charge stored in the charging/discharging unit (140), apply current to the first charging/discharging path (c), and charge the cell assembly (110) using the energy stored in the charging/discharging unit (140).

In this way, the charging/discharging unit (140) consumes the charging current from the other parallel-connected battery pack (200) in an environment where the battery cells should not be charged, enhancing the safety of the battery pack (100). In the normal temperature range, the charging current stored in the charging/discharging unit (140) is used to charge the cell assembly (110) of the battery pack (100), thereby preventing unnecessary inter-pack charging and enabling efficient energy use.

The control unit (150) may be a processor of a battery management system (not shown) and may be configured with a device such as an MCU (Micro Control Unit). The control unit (150) can control the operating state of the first and second charging/discharging switches (120)(130) to be turned on or off. As an embodiment, in an abnormal temperature environment of the battery pack (100), the control unit (150) controls the first charging/discharging switch (120) to turn off, disconnecting the first charging/discharging path (c), and controls the second charging/discharging switch (130) to turn on, connecting the second charging/discharging path (d). After the charging/discharging unit (140) is sufficiently charged, it disconnects the second charging/discharging path (d). In a normal temperature environment of the battery pack (100), the control unit (150) controls the first charging/discharging switch (120) to turn on, connecting the first charging/discharging path (c) so that the charging current from the other battery pack (200) charges the cell assembly (110).

At this time, by turning on the second charging/discharging switch (130) to connect the second charging/discharging path (d), the charging current from the charging/discharging unit (140) can be made to charge the cell assembly (110) through the second charging/discharging path (d) and the first charging/discharging path (c).

While the charge stored in the charging/discharging unit (140) is being discharged, the operating state of the second charging/discharging switch (130) is controlled to be turned on. As the charge in the charging/discharging unit (140) is discharged, current is applied to the first charging/discharging path (c). The control unit (150) then measures the voltage of the charging/discharging unit (140), and if it confirms that all the stored charge has been discharged, it controls the operating state of the second charging/discharging switch (130) to turn off, thereby disconnecting the second charging/discharging path (d).

The pack input/output terminals (a+, a-) can be electrically connected to the pack input/output terminals (b+, b-) of another battery pack (200) mounted in the battery system (S) and to the system input/output terminals (P+, P-) of the battery system (S), respectively.

Meanwhile, although the control of the operating state of the first and second charging/discharging switches (120)(130) is described as being divided into abnormal and normal temperatures, this is just one condition used due to the characteristic of battery cells that their maximum charging voltage is greatly affected by temperature, and is not limited thereto. That is, various conditions can be used according to the overcharging occurrence conditions of the battery cells using the PS (power specification) of the battery cells. However, in this specification, for the sake of clear and concise explanation, the conditions are limited to abnormal and normal temperatures.

Hereinafter, a method for controlling the charging/discharging of a battery pack according to an embodiment of the present invention will be described. The method for controlling the charging/discharging of a battery pack according to an embodiment of the present invention may be a method for processing a received signal using the aforementioned battery pack for charge/discharge control, and thus, the contents described above with respect to the battery pack for charge/discharge control may be applied as they are, so a redundant description may be omitted.

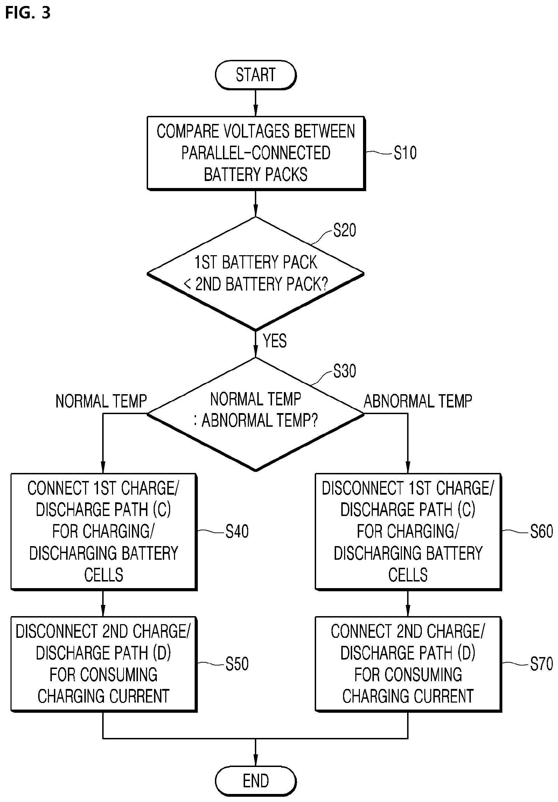

FIG. 3 is a flowchart for explaining a method for controlling the charging/discharging of a battery pack according to an embodiment of the present invention.

Referring to FIG. 3, a method for controlling the charging/discharging of a battery pack according to an embodiment of the present invention involves the control unit (150) detecting whether a first battery pack (100) is electrically connected in parallel with another second battery pack (200) via CAN communication and checking and comparing their voltages (S10).

As a result of the comparison (S10), if the voltage of the first battery pack (100) is lower than the voltage of the second battery pack (200) (S20), and the temperature of the first battery pack (100) is within a predetermined normal temperature range (S30), the control unit (150) controls the operating state of the first charging/discharging switch (120) configured in the first battery pack (100) to be turned on, thereby connecting the first charging/discharging path (c) for charging/discharging the battery cells (110) (S40). Here, the normal temperature range is a suitable temperature range for charging according to the specifications defined in the PS of the battery cell (110), for example, a range between 0°C and 55°C during charging.

In the suitable temperature range, the control unit (150) controls the operating state of the second charging/discharging switch (130) configured in the first battery pack (100) to be turned off, thereby disconnecting the second charging/discharging path (d) that consumes the charging current applied from the second battery pack (200) (S50).

Also, as a result of the comparison (S10), if the voltage of the first battery pack (100) is lower than the voltage of the second battery pack (200) (S20), and the temperature of the first battery pack (100) is within an abnormal temperature range (S30), the control unit (150) controls the operating state of the first charging/discharging switch (120) configured in the first battery pack (100) to be turned off, thereby disconnecting the first charging/discharging path (c) for charging/discharging the battery cells (110) (S60). Here, the abnormal temperature range is a temperature range in which charging is not possible according to the specifications defined in the PS of the battery cell (110), preferably a low temperature below 0°C or a high temperature above 55°C.

In such an abnormal temperature range, the control unit (150) controls the operating state of the second charging/discharging switch (130) configured in the first battery pack (100) to be turned on, thereby connecting the second charging/discharging path (d) that consumes the charging current applied from the second battery pack (200) (S70).

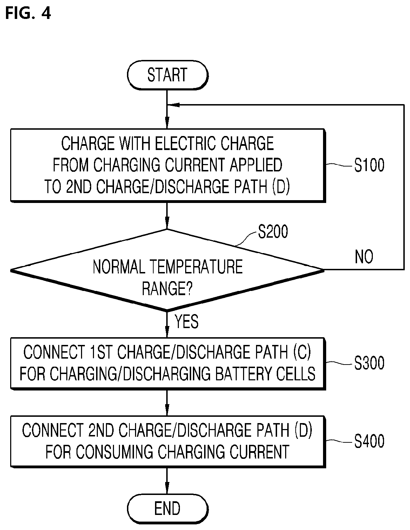

FIG. 4 is a flowchart for explaining the method of consuming charging current in FIG. 3.

Referring to FIG. 4, the charge from the charging current applied to the second charging/discharging path (d) is stored in the charging/discharging unit (140) (S100). When the charging/discharging unit (140) is sufficiently charged, the second charging/discharging path (d) is disconnected to stop charging.

After the charge is stored in the charging/discharging unit (140), if the temperature of the first battery pack (100) falls within the normal temperature range (S200), the control unit (150) controls the operating state of the first charging/discharging switch (120) to be turned on, connecting the first charging/discharging path (c) for charging/discharging the battery cells (110) (S300), and simultaneously controls the operating state of the second charging/discharging switch (130) to be turned on, connecting the second charging/discharging path (d) so that the charging current from the charging/discharging unit (140) is applied to the first charging/discharging path (c) (S400).

In this way, as both the first charging/discharging path (c) and the second charging/discharging path (d) are connected, the charge stored in the charging/discharging unit (140) is discharged and the charging current is applied to the first charging/discharging path (c), allowing the charging current applied from the second battery pack (200) to charge the first battery pack (100).

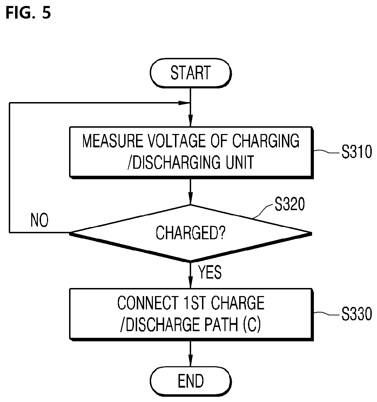

Meanwhile, FIG. 5 is a flowchart for explaining step S300 of FIG. 4 in detail. The step S300 involves the control unit (150) measuring the voltage of the charging/discharging unit (140) to determine that the charging/discharging unit (140) is sufficiently charged (S310).

As a result of the determination, if the charging/discharging unit (140) is sufficiently charged (S320), the control unit (150) controls the operating state of the second charging/discharging switch (130) to be turned on, thereby connecting the secondcharging/discharging path (c) (S330).

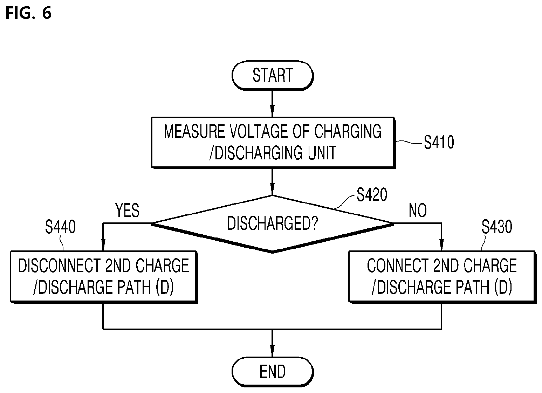

FIG. 6 is a flowchart for explaining step S400 of FIG. 4 in detail. The step S400 involves the control unit (150) measuring the voltage of the charging/discharging unit (140) to determine that the charge in the charging/discharging unit (140) has been discharged (S410).

As a result of the determination, if the charge stored in the charging/discharging unit (140) has not been fully discharged (S420), the control unit (150) controls the operating state of the second charging/discharging switch (130) to remain turned on, maintaining the connection of the second charging/discharging path (d) (S430).

As a result of the determination, if the charge stored in the charging/discharging unit (140) has been fully discharged (S420), the control unit (150) controls the operating state of the second charging/discharging switch (130) to be turned off, thereby disconnecting the second charging/discharging path (d) (S440).

In this way, the second charging/discharging path (d) is connected only when the charging/discharging unit (140) is charged, and after the stored charge in the charging/discharging unit (140) is fully discharged, the second charging/discharging path (d) is disconnected again.

Meanwhile, when a load is connected to the battery packs (100, 200) and they begin to discharge, the control unit (150) can disconnect the charging/discharging path (d) so that only the current from the cell assembly flows to the load, thereby ensuring voltage stability for the load.

While the preferred embodiments of the present invention have been described and illustrated using specific terms, such terms are used only for the purpose of clearly explaining the invention, and it is apparent that various changes and modifications can be made to the embodiments and the described terms without departing from the technical spirit and scope of the following claims. Such modified embodiments should not be understood separately from the spirit and scope of the present invention but should be considered to fall within the scope of the claims of the present invention.

The reference numerals used in the specification and drawings are described below.
100, 200: Battery pack 110: Cell assembly
120: First charging/discharging switch 130: Second charging/discharging switch
140: Charging/discharging unit 150: Control unit
S: Battery system c: First charging/discharging path
d: Second charging/discharging path

## Claims

1. A battery pack, comprising:
a cell assembly comprising a plurality of battery cells and electrically connected to pack input/output terminals (a+, a-) through a first charging/discharging path (c);
a first charging/discharging switch configured between the cell assembly and the pack input/output terminal (a+), for connecting or disconnecting the first charging/discharging path (c) according to a turn-on or turn-off operating state;
a second charging/discharging switch configured on a path that branches off between the first charging/discharging switch and the pack input/output terminal (a+) and connects to the pack input/output terminal (a-), for connecting or disconnecting a second charging/discharging path (d) according to a turn-on or turn-off operating state;
a charging/discharging unit configured between the second charging/discharging switch and the pack input/output terminal (a-), for consuming a charging current applied between parallel-connected battery packs; and
a control unit for controlling the operating state of the first and second charging/discharging switches to a turn-on or turn-off state.

2. The battery pack of claim 1, wherein
the first charging/discharging switch is turned off under an abnormal temperature environment in which a charging problem occurs, thereby disconnecting the first charging/discharging path (c), and
is turned on under a normal temperature environment other than the abnormal temperature environment, thereby connecting the first charging/discharging path (c).

3. The battery pack of claim 1, wherein
the second charging/discharging switch is turned on under an abnormal temperature environment in which a charging problem occurs, thereby connecting the second charging/discharging path (d).

4. The battery pack of claim 1, wherein
the charging/discharging unit stores charge from a current supplied from the first charging/discharging path (c)in an abnormal temperature environment in which a charging problem occurs, and
discharges the charge stored therein to supply a current to the first charging/discharging path (c) in a normal temperature environment other than the abnormal temperature.

5. The battery pack of claim 1, wherein
the control unit controls the first charging/discharging switch to be turned off and the second charging/discharging switch to be turned on in an abnormal temperature environment in which a charging problem occurs, and
controls the first charging/discharging switch to be turned on and the second charging/discharging switch to be turned on in a normal temperature environment other than the abnormal temperature environment, thereby causing the cell assembly to be charged.

6. The battery pack of claim 1, wherein
the control unit, upon connection of the battery pack, checks a connection status with the battery pack and a voltage of the battery pack via CAN communication to compare voltages between the connected battery packs.

7. The battery pack of claim 1, wherein
the control unit measures a voltage of the charging/discharging unit to check a charge and discharge state of the charging/discharging unit.

8. The battery pack of claim 7, wherein
the control unit controls the operating state of the second charging/discharging switch to be turned on while a charge stored in the charging/discharging unit is being discharged, and
controls the operating state of the second charging/discharging switch to be turned off once all the charge stored in the charging/discharging unit has been discharged.

9. The battery pack of claim 1, wherein
the pack input/output terminals (a+, a-) are electrically connected to pack input/output terminals (b+, b-) of another battery pack mounted in a battery system (S) and to system input/output terminals (P+, P-) of the battery system (S), respectively.

10. The battery pack of any one of claims 2 to 5, wherein the abnormal temperature is a low temperature of 0°C or below or a high temperature of 55°C or above, and the normal temperature is a temperature between 0°C and 55°C.

11. A method for controlling charging/discharging of a battery pack, the method comprising the steps of:
(A) detecting, by a control unit, whether a first battery pack is electrically connected in parallel with a second battery pack via CAN communication, and checking a voltage of the first battery pack connected in parallel;
(B) connecting a first charging/discharging path (c) for charging/discharging battery cells if the voltage of the first battery pack is lower than a voltage of the second battery pack and a temperature of the first battery pack is within a normal temperature range where there is no problem in charging;
(C) disconnecting the first charging/discharging path (c) if the voltage of the first battery pack is lower than the voltage of the second battery pack and the temperature of the first battery pack is within an abnormal temperature range where a problem occurs in charging;
(D) connecting a second charging/discharging path (d) for consuming a charging current applied from the second battery pack (200); and
(E) consuming, by a charging/discharging unit, the charging current applied to the second charging/discharging path (d).

12. The method for controlling charging/discharging of the battery pack of claim 11, wherein
the step (B) further comprises disconnecting the second charging/discharging path (d) configured to consume the charging current supplied from the second battery pack.

13. The method for controlling charging/discharging of the battery pack of claim 12, wherein the step (B) comprises the steps of:
controlling, by the control unit, an operating state of a first charging/discharging switch configured in the first battery pack to be turned on to connect the first charging/discharging path (c); and
controlling, by the control unit, an operating state of a second charging/discharging switch configured in the first battery pack to be turned off to disconnect the second charging/discharging path (d).

14. The method for controlling charging/discharging of the battery pack of claim 11, wherein
the step (C) comprises the step of controlling, by the control unit, an operating state of a first charging/discharging switch configured in the first battery pack to be turned off to disconnect the first charging/discharging path (c).

15. The method for controlling charging/discharging of the battery pack of claim 11, wherein
the step (D) comprises the step of controlling, by the control unit, an operating state of a second charging/discharging switch configured in the first battery pack to be turned on to connect the second charging/discharging path (d).

16. The method for controlling charging/discharging of the battery pack of claim 11, wherein
the step (E) comprises the steps of:
(E1) charging the charging/discharging unit with an electric charge from the charging current applied to the second charging/discharging path (d); and
(E2) after the charging/discharging unit has been charged, if the temperature of the first battery pack is within the normal temperature range, connecting the first charging/discharging path (c) and the second charging/discharging path (d), thereby allowing a current from the charging/discharging unit to flow through to the first charging/discharging path (c).

17. The method for controlling charging/discharging of the battery pack of claim 16, wherein the step (E2) comprises the steps of:
measuring, by the control unit, a voltage of the charging/discharging unit to determine that the charging/discharging unit has been charged; and
if, as a result of the determination, the charging/discharging unit has been charged, controlling, by the control unit, an operating state of a first charging/discharging switch to be turned on to connect the first charging/discharging path (c).

18. The method for controlling charging/discharging of the battery pack of claim 16, wherein the step (E2) further comprises the steps of:
measuring, by the control unit, a voltage of the charging/discharging unit to determine that a charge in the charging/discharging unit has been discharged;
if, as a result of the determination, the charge stored in the charging/discharging unit has not been fully discharged, controlling, by the control unit, an operating state of a second charging/discharging switch to be turned on to connect the second charging/discharging path (d); and
if, as a result of the determination, the charge stored in the charging/discharging unit has been fully discharged, controlling, by the control unit, the operating state of the second charging/discharging switch to be turned off to disconnect the second charging/discharging path (d).
